Europäisches Patentamt

European Patent Office

Office européen des brevets

(11) Veröffentlichungsnummer: **0 479 118 A2**

## (12) EUROPÄISCHE PATENTANMELDUNG

(21) Anmeldenummer: **91116398.8**

(22) Anmeldetag: **26.09.91**

(51) Int. Cl.⁵: **H01S 3/133**, G01K 11/00, G01R 33/00, G01H 9/00, G01D 5/26

(30) Priorität: **04.10.90 DE 4031372**

(43) Veröffentlichungstag der Anmeldung: **08.04.92 Patentblatt 92/15**

(84) Benannte Vertragsstaaten: **DE FR GB**

(71) Anmelder: **DORNIER GMBH Postfach 1420**

**W-7990 Friedrichshafen 1(DE)**

(72) Erfinder: **Walker, Karl-Heinz, Dr. Baitenhauser Strasse 6 W-7758 Daisendorf(DE)**

(74) Vertreter: **Kasseckert, Rainer DORNIER GMBH Kleeweg 3 W-7990 Friedrichshafen 1(DE)**

(54) **Vorrichtung zur Frequenzstabilisierung einer Laserdiode.**

㉗ Vorrichtung zur Frequenzstabilisierung einer Laserdiode (2), mit einer Glasfaser (8), einem faseroptischen Koppler (10), einem in eine Faser eingefügten faseroptischen Fabry-Perot-Interferometer (12), einem geeigneten Kühlelement (13) zur Temperaturstabilisierung des faseroptischen Interferometers (12), mit zwei optischen Detektoren (14, 16) zur Aufnahme des vom Interferometer transmittierten Lichtes und des Referenzlichtes und mit einer Elektronik zur Aufnahme der Signale der optischen Detektoren und zur Steuerung des Laserdiodenstromes.

Fig.1

EP 0 479 118 A2

Die Erfindung betrifft eine Vorrichtung zur Frequenzstabilisierung einer Laserdiode mit einem Regelkreis zur Steuerung des Laserdiodenstromes.

Laserdioden finden ein weites Einsatzfeld im Bereich der Kommunikationstechnik, der Spektroskopie, der Interferometrie und der Sensorik. Eine Limitierung dieser Einsatzmöglichkeiten erfolgt in der Regel durch eine starke Frequenzänderung des Laserdiodenlichtes im Betrieb, hervorgerufen durch Temperaturänderungen und Signalrückkopplung in die Laserdiode. Im Bereich der Standardkommunikationstechnik reicht in der Regel eine grobe Temperaturstabilisierung mit Hilfe von Peltierkühlelementen aus. Bei interferometrischen Anwendungen, wie z.B. bei faseroptischen interferometrischen Sensoren, reicht dies nicht aus. Hier hängt die zu erreichende Meßauflösung direkt von der Frequenzstabilität der Laserdiode ab.

Der Erfindung liegt die Aufgabe zugrunde, eine Vorrichtung anzugeben, mit der die Frequenz einer Laserdiode so stabilisiert werden kann, daß ein Einsatz als Lichtquelle für hochempfindliche, faseroptische Sensoren möglich ist. Die Vorrichtung soll einfach, stabil, kompakt und preiswert sein.

Die Aufgabe wird durch eine Vorrichtung zur Stabilisierung von Laserdioden nach Anspruch 1 gelöst. Ausgestaltungen der Erfindung und Meßgeräte sind Gegenstände von Unteransprüchen.

Gemäß der Erfindung wird eine Vorrichtung angegeben, bei dereine Frequenzveränderung der Laserdiode durch ein faseroptisches Fabry-Perot-Interferometer mit nachfolgendem optischen Detektor gemessen und über einen elektrischen Regelkreis korrigiert wird.

Das (modulierte) Licht einer Laserdiode wird erfindungsgemäß über eine geeignete Koppeleinrichtung in eine (bevorzugt Einmoden-)Lichtleitfaser eingekoppelt und einem, auf konstanter Temperatur befindlichen faseroptischen Fabry-Perot-Interferometer zugeführt.

Frequenzveränderungen des Laserdiodenlichtes führen dann zu Änderungen der Transmissions- oder Reflexionscharakteristik des Interferometers. Die entsprechenden Intensitätsverändetungen werden zum Beispiel in Transmission mit einem Photodetektor gemessen und in elektrische Signale umgewandelt. Zusätzlich wird ein Referenzsignal der Referenz f zur Signalnormierung aufgenommen. Mit an sich bekannter Lock-In-Technik wird ein Regelsignal der doppelten Frequenz 2f generiert und einem PID-Regler zugeführt. Dieser regelt über eine Laserdiodenansteuerung entsprechend den Strom der Laserdiode.

Als Arbeitspunkt für den Regler kann zum Beispiel der Null-Durchgang des 2f-Regelsignales gewählt werden. Eine Frequenzzunahme des emittierten Lichtes erzeugt dann ein positives Signal und erhöht über den PID-Regler den Laserdiodenstrom so lange, bis die Frequenz entsprechend reduziert ist. Im Falle einer Frequenzabnahme erfolgt entsprechend eine Abnahme des Laserdiodenstromes und eine Zunahme der Laserfrequenz.

Über einen geeigneten optischen Koppler kann das frequenzstabilisierte Laserdiodenlicht ausgekoppelt werden und steht dann als universelle Lichtquelle für verschiedenste Anwendungen zur Verfügung.

Die Herstellung eines erfindungsgemäßen Interferometers erfolgt zum Beispiel durch Schneiden einer Einmoden-Faser, Beschichtung des Faserendes mit einer dünnen Metallschicht, z.B. mit einer 30 $\mu$m Chromschicht, oder mit einer dielektrischen Schicht und anschliessender Verschweißung mit einem weiteren Faserstück, das nach einigen Millimetern abgeschnitten und verspiegelt wird.

Die Beschichtungen der Verspiegelungen können z.B. auch durch Aufbringen dünner Titandioxidschichten erfolgen.

In einer Ausführung der Erfindung ist neben dem Interferometer auch die Laserdiode zur Temperaturstabilisierung auf ein Kühlelement, insbesondere ein Peltier-Kühlmodul, montiert.

Die Elektronik zur Signalaufnahme und zur Laserdiodensteuerung besteht zum Beispiel aus einem Dividierer für die beiden Eingänge der lichtaufnehmenden Dioden, einem Frequenzgenerator, einem Lock-In-Verstärker, einer Laserdiodenstromquelle und einem PID-Regler.

Mit dem erfindungsgemäßen Gerät lässt sich ein faseroptischer Sensor zur Messung von Temperatur, Druck, Schall oder Magnetfeldern herstellen, bei dem ein Fabry-Perot-Interferometer der Meßgröße ausgesetzt ist. Dieses Fabry-Perot-Interferometer wird mit frequenzstabilisiertem Licht gemäß der Erfindung bedient.

In einer Ausführung können mehrere faseroptische Sensoren, die im Abstand von einigen Millimetern oder einigen Zentimetern in eine Faser angeordnet sind, zu einem Mehrpunktsensorsystem aufgebaut werden. Diese Sensoren liegen hintereinander in einer Faser. Es kann somit ein Sensor-Array aufgebaut werden, das die minimalen Abmessungen einer Faser hat, aber an mehreren Stellen im Abstand von z.B. einigen Zentimetern eine quasi simultane Meßwerterfassung erlaubt. Dies ist besonders für medizinische Anwendungen wichtig, da damit eine nur schwach invasive Meßwertermittlung möglich ist.

Zur optimalen Einkopplung des Laserdiodenlichtes in eine Einmoden-Glasfaser kann eine Grin-Linsen-Optik benutzt werden. Diese besteht aus einer Grin-Linse mit geeigneter Brennweite, die auf das Faserende direkt aufgeklebt ist. Dies hat den Vorteil einer einfachen, preiswerten und vorallem stabilen Lichteinkopplung.

In einer Ausführung kann die Einkopplung des Laserdiodenlichtes über eine Faseraufweitung (Faser-Taper) erfolgen.

Zur Integration und Entkopplung kann an das Fabry-Perot-Interferometer eine weitere Faser angeschweißt sein, so daß das Licht direkt über diese Faser weiter geleitet und einer Photodiode zugeführt werden kann. Auf diese Weise lassen sich störende Einflüsse auf die Signalaufnahme, bedingt durch Koppplereinflüsse und Rückreflexe aus dem System, weitgehend ausschliessen.

Das faseroptische Fabry-Perot-Interferometer kann auch durch gezielte Diffusion von Metallionen in die Faser hergestellt werden. Dabei fallen die kritische Beschichtung sowie die anschliessende Verschweißung der Fasern weg.

Die Erfindung wird anhand von drei Figuren näher erläutert.

Die Fig. 1 und 2 zeigen zwei Vorrichtungen zur Frequenzstabilisierung von Laserdioden.
Fig. 3 zeigt einen Temperatursensor, der frequenzstabilisiertes Laserdiodenlicht verwendet.

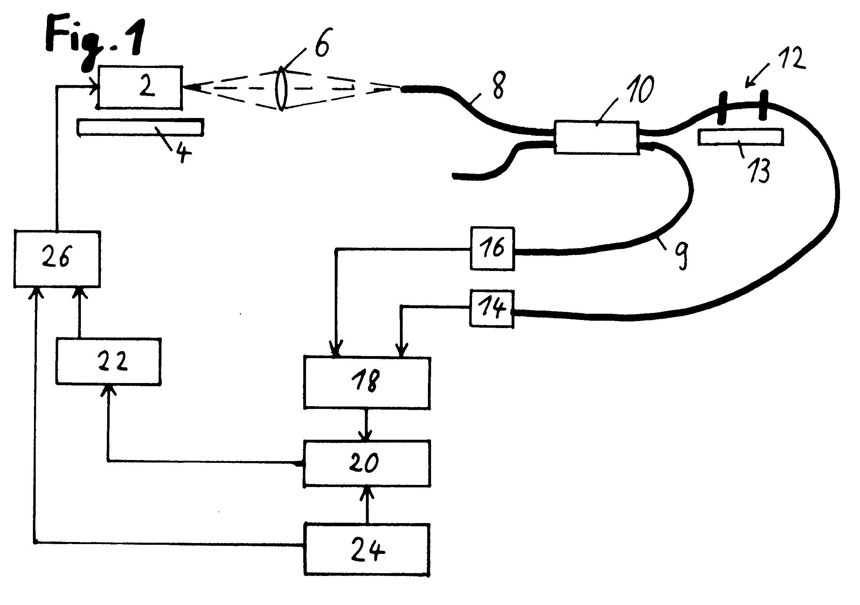

Fig. 1 zeigt schematisch einen Aufbau zur Frequenzstabilisierung einer Laserdiode **2** mit einem faseroptischen Fabry-Perot-Interferometer **12**. Die Laserdiode **2** wird durch ein Peltier-Element **4** grob auf einer konstanten Betriebstemperatur gehalten. Die Grundstromeinstellung und die Modulation des Laserstromes erfolgt über eine mittels Frequenzgenerator **24** gesteuerte Laseransteuerung **26**. Das von der Laserdiode **2** emittierte Licht wird hier mit Hilfe einer Optik **6** in einen Einmoden-Lichtquellenleiter **8** eingekoppelt - möglich ist auch die direkte Einstrahlung in den Faseranfang - und in einem sich anschliessenden faseroptischen Koppler **10** aufgeteilt. In einem Zweig (hier oben gezeichnet) des Kopplerausganges ist in die Faser ein faseroptisches Fabry-Perot-Interferometer **12** eingefügt. Ein Kühlelement **13**, das beispielsweise ein Peltier-Element sein kann, hält das Interferometer **12** auf einer konstanten Temperatur, so daß sich dessen Transmissionscharakteristik nicht verändert. Die transmittierten Lichtintensitäten hinter dem Interferometer **12** werden dann zum Beispiel durch einen angespleißten Lichtwellenleiter aufgenommen und dem Photodetektor **14** zugeführt. Die Grundintensität des Lichtes wird über den Referenzzweig **9** des Kopplers **10** mit dem Photodetektor **16** ermittelt.

Die elektrischen Signale aus den Photodetektoren **14** und **16** werden hier einem Dividierer **18** zugeführt. Das normierte Ausgangssignal geht in den Eingang eines Lock-In-Verstärkers **20**, wird dort demoduliert und regelt über die Ansteuerung **26** den Strom der Laserdiode **2**.

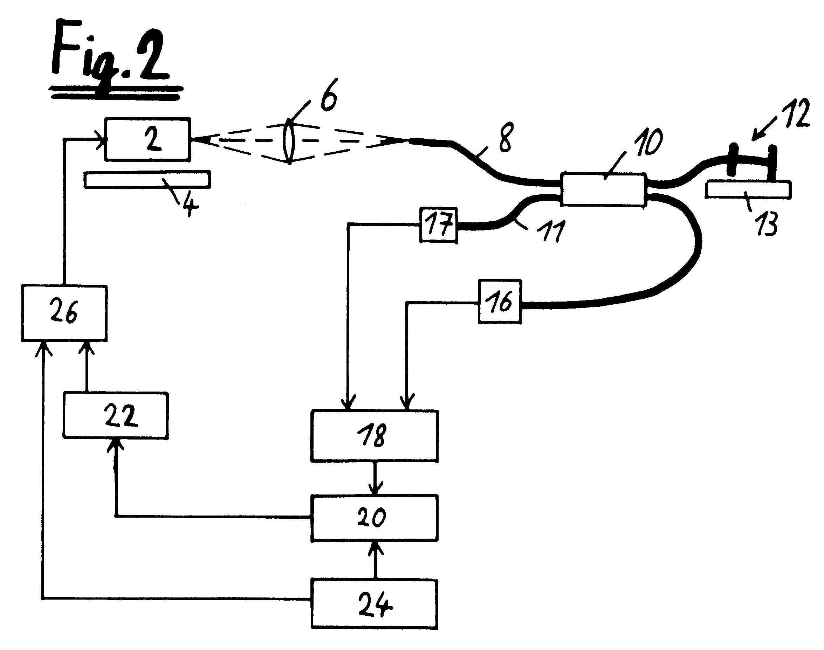

Fig. 2 zeigt eine weitere Ausführung der Erfindung, bei der statt des transmittierten Lichtes das vom Fabry-Perot-Interferometer **12** reflektierte Licht gemessen wird. In diesem Fall wird die Reflexionsänderung des faseroptischen Interferometers **12** in dem separaten Kopplerzweig **11** mit der Photodiode **17** gemessen und dann - entsprechend Fig. 1 - über den Dividierer **18**, den Lock-In-Verstärker **20** und den PID-Regler **22** zur Regelung des Laserdiodenstromes benutzt.

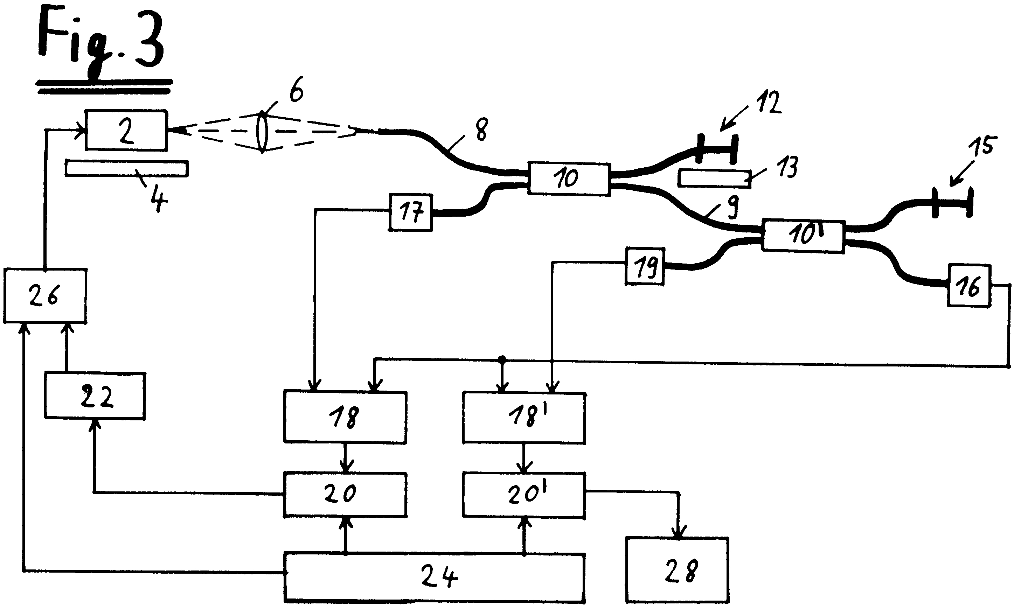

Fig. 3 zeigt eine weitere Ausführungsform, in Anwendung eines faseroptischen Temperatursensors **15**.

In dieser Ausführung ist am Ende des Lichtwellenleiter **9** ein weiterer faseroptischer Koppler **10'** angebracht. An einem Ausgang des Kopplers **10'** wird mit einer Photodiode **16** das Referenzsignal abgenommen. An dem zweiten Ausgang des Kopplers **10'** wird das frequenzstabilisierte Nutzsignal einem weiteren faseroptischen Fabry-Perot-Interferometer **15** zugeführt. Mit Hilfe eines weiteren Dividierers **18'** und Lock-In-Verstärkers **20'** sowie anschliessender Signalauswerteeinheit **28** können zum Beispiel Temperaturen exakt ermittelt werden. Die Temperaturänderungen des nicht temperaturstabilisierten Interferometers **15** bewirken, bedingt durch Brechungsindexänderungen, eine Phasenverschiebung und entsprechend eine Signalveränderung, die mit der Temperaturveränderung skaliert.

**Patentansprüche**

1. Vorrichtung zur Frequenzstabilisierung einer Laserdiode (**2**), **gekennzeichnet durch**
   - eine Glasfaser (**8**),
   - einen faseroptischen Koppler (**10**),
   - ein, in eine Faser eingefügtes faseroptisches Fabry-Perot-Interferometer (**12**),
   - ein geeignetes Kühlelement (**13**) zur Temperaturstabilisierung des faseroptischen Interferometers (**12**),
   - zwei optische Detektoren (**14, 16, 17**) zur Aufnahme des vom Interferometer transmittierten (oder reflektierten) Lichtes und des Referenzlichtes und
   - eine Elektronik zur Aufnahme der Signale der optischen Detektoren und zur Steuerung des Laserdiodenstromes.

2. Vorrichtung nach Anspruch 1, **gekennzeichnet durch** ein faseroptisches Fabry-Perot-Interferometer, hergestellt durch Schneiden einer Einmoden-Faser, Beschichtung des Faserendes mit einer dünnen Metallschicht, z.B. mit einer 30 $\mu$m Chromschicht, oder einer dielektrischen Schicht und anschliessender Verschweißung mit einem weiteren Faserstück, das nach einigen Millimetern oder nach einigen Zentimetern abgeschnitten und verspiegelt wurde.

3. Vorrichtung nach Anspruch 1, **dadurch gekennzeichnet,** daß das faseroptische Fabry-Perot-Interferometer (**12**) durch Aufbringen dünner Titandioxidschichten gebildet ist.

4. Vorrichtung nach einem der vorhergehenden Ansprüche, **dadurch gekennzeichnet,** daß das Interferometer (**12**) und die Laserdiode (**2**) zur Temperaturstabilisierung auf ein Kühlelement (**13** oder **4**) montiert sind.

5. Vorrichtung nach einem der vorhergehenden Ansprüche, **dadurch gekennzeichnet,** daß die Elektronik zur Signalaufnahme und zur Laserdiodensteuerung einen Dividierer (**18**), einen Frequenzgenerator (**24**), einen Lock-In-Verstärker (**20**), eine Laserdiodenstromquelle (**26**) und einen PID-Regler (**22**) enthält.

6. Vorrichtung nach einem der vorhergehenden Ansprüche, **dadurch gekennzeichnet,** daß das das verwendete Kühlelemente (**13**) ein Peltier-Kühlelement ist.

7. Vorrichtung nach nach einem der vorhergehenden Ansprüche, **dadurch gekennzeichnet,** daß zur Einkopplung des Laserdiodenlichtes eine Grin-Linsen-Optik oder ein Faser-Taper verwendet ist.

8. Vorrichtung nach einem der vorhergehenden Ansprüche, **dadurch gekennzeichnet,** daß zur Integration und Entkopplung der Signalaufnahme vom restlichen System an das Fabry-Perot-Interferometer (**12**) eine weitere Faserangeschweißt ist, so daß das Licht von einer Photodiode (mit Pigtail) direkt gemessen werden kann.

9. Vorrichtung nach einem der vorhergehenden Ansprüche, **dadurch gekennzeichnet,** daß das faseroptische Fabry-Perot-Interferometer (**12**) durch räumlich definierte Diffusion von Metallionen in die Faser hergestellt ist.

10. Temperatursensor mit zwei Fabry-Perot-Interferometern, von denen eines auf einer konstanten Temperatur liegt und das andere auf der zu messenden Temperatur.

11. Faseroptischer Sensor zur Messung von Temperatur, Druck, Schall oder Magnetfeldern, mit einem der Meßgröße ausgesetzten Fabry-Perot-Interferometer (**15**) und einer Vorrichtung zur Abgabe frequenzstabililisierten Lichtes nach einem der vorhergehenden Ansprüche.

12. Mehrpunktsensor zur Messung von Temperatur, Druck, Schall oder Magnetfeldern nach Anspruch 11, **gekennzeichnet durch** mehrere in eine Faser im Bereich von Millimetern oder Zentimetern aufeinanderfolgende Fabry-Perot-Interferometer.

Fig. 1

EP 0 479 118 A2

Fig. 2

# Fig.3

EP 0 479 118 A2